# EUROPÄISCHE PATENTSCHRIFT

(11) **EP 2 165 207 B1**
(45) Veröffentlichungstag und Bekanntmachung des Hinweises auf die Patenterteilung: **01.03.2017**
(21) Anmeldenummer: 08759683.9
(22) Anmeldetag: 16.05.2008
(51) Int. Cl.: H01M 10/48, G01R 31/36

(54) **VORRICHTUNG ZUR ANZEIGE DES LADEZUSTANDES EINES AKKUS**
APPARATUS FOR INDICATING THE STATE OF CHARGE OF A STORAGE BATTERY
DISPOSITIF POUR INDIQUER LE NIVEAU DE CHARGE D'UN ACCUMULATEUR

(30) Priorität: 06.07.2007 DE 102007031566
(43) Veröffentlichungstag der Anmeldung: 24.03.2010
(73) Patentinhaber: Robert Bosch GmbH, 70442 Stuttgart (DE)
(72) Erfinder: OSSWALD, Alexander, 70599 Stuttgart (DE); HEINRICH, Thomas, 70771 Leinfelden (DE)
(86) Internationale Anmeldenummer: PCT/EP2008/056045
(87) Internationale Veröffentlichungsnummer: WO 2009/007161

(56) Entgegenhaltungen:
- WO-A-92/15893
- DE-A1- 4 036 479
- DE-A1- 4 106 725
- DE-A1- 10 009 618
- DE-A1- 10 201 397
- US-A- 5 831 415

## Beschreibung

Die Erfindung betrifft einen Akku für ein Elektrowerkzeug, mit einer wiederaufladbaren Batterie mit einer Ladezustandsschaltung, die eine Auswerteeinheit zum Auswerten des Ladezustands der Batterie und einer Ladezustandsanzeige aufweist. Weiterhin betrifft die Erfindung ein Verfahren zur Anzeige des Ladezustandes einer wiederaufladbaren Batterie eines Akkus mit einer Ladezustandsschaltung, die eine Auswerteeinheit zum Auswerten des Ladezustands der Batterie und einer Ladezustandsanzeige aufweist.

Wiederaufladbare Batterien, stehen heute in unterschiedlichen Typen und Größen für eine Vielzahl von Anwendungen zu Verfügung. Typische Arten für derartige wiederaufladbare Batterien sind entsprechend der in ihnen jeweils enthaltenen Komponenten beispielsweise Bleisäure-, Nickelkadmium- (NiCd), Nickelmetallhydrid- (NiMH), Lithiumionen- (LiIo) oder Lithiumpolymer-Batterien. Diese können vielfach benutzt und in einem geeigneten Ladegerät wieder aufgeladen werden. Im Rahmen der vorliegenden Anmeldung wird unter einem Akku eine wiederaufladbare Batterie verstanden, die neben der wiederaufladbaren Batterie oder dem wiederaufladbaren Batteriepack selbst wenigstens eine weitere Komponente, wie etwa eine elektronische Schaltung, elektrische Anschlüsse oder einen Verriegelungsmechanismus zum Anschluss an ein Elektrowerkzeug aufweist. Bei solchen Akkus kann eine Ladezustandsanzeige vorgesehen sein, mit deren Hilfe es dem Benutzer möglich ist, den aktuellen Ladezustand der Batterie zu erkennen. Dabei kann der Ladezustand auf unterschiedliche Weise angezeigt werden. Beispielsweise kann dies mit Hilfe einer einzigen Leuchtdiode, die etwa in grüner Farbe einen betriebsbereiten Ladezustand anzeigt erfolgen. Auch kann mit Hilfe einer Mehrzahl von Leuchtdioden eine genauere Anzeige des Ladezustands verwirklicht werden, wobei beispielsweise eine Mehrzahl von Leuchtdioden vorgesehen ist, von denen entsprechend dem jeweiligen Ladezustand, unterschiedlich viele leuchten.

Hierzu ist aus der DE 102 01 397 A1 eine Vorrichtung zur Anzeige des Ladezustandes eines an ein Elektrogerät angeschlossenen Akkus bekannt. Diese weist Mittel auf, welche die Ladezustandsanzeige während des Betriebes des Elektrogerätes deaktivieren.

Außerdem ist aus der DE 4 106 725 A1 ein Akku mit einer Schaltungsanordnung zur Ladezustandsanzeige für eine wiederaufladbare Batterie bekannt. Diese kann beispielsweise für den Betrieb einer Maschine, insbesondere einer Handwerkzeugmaschine wie einem Akkubohrern oder einem Akkuschraubern verwendet werden. Hierbei wird durch eine Integration eines im Lastkreis fließenden Stroms der Ladezustand der Batterie ermittelt. Der jeweils aktuelle Ladezustand wird mit einer Ladezustandsanzeige angezeigt. Der Ladezustand wird im oder am Gehäuse der Batterie angezeigt, wobei beispielsweise vier Leuchtdioden den aktuellen Ladezustand in 25% Schritten angeben können. Aus diesem Dokument ist auch bereits bekannt, die Ladezustandsanzeige manuell zu- und abschaltbar zu gestalten.

Oftmals wird die Ladezustandsanzeige durch einen Mikroprozessors unterstützt, der gewährleistet, dass eine Kommunikation zwischen dem Akku, dem Ladegerät und der mit dem Akku betriebenen Maschine erfolgen kann. Ergibt sich aus dieser Kommunikation, dass die wiederaufladbare Batterien gegenwärtig geladen oder durch die Maschine entladen wird, so wird eine die Ladezustandsanzeige gesperrt bzw. dem Benutzer mitgeteilt, dass gegenwärtig eine Anzeige des Ladezustands nicht möglich ist. Sofern ein derartiger Mikroprozessor in der Ladezustandsanzeige, beispielsweise aus Kostengründen, nicht eingesetzt werden soll, hat dies zur Folge, dass die unterschiedlichen Betriebszustände nicht unterschieden werden können und die Ladezustandsanzeige falsche Werte angibt.

Erfindungsgemäß wird nun eine Ladezustandsanzeige vorgeschlagen, die eine Schaltungsanordnung aufweist, mit der eine Ausgabe des richtigen Wertes des Ladezustands ermöglicht wird ohne dass ein Mikroprozessor zur Betriebszustandsermittlung vorgesehen werden muss. Hierzu wird in der Ladezustandsschaltung ein als NTC ausgeführter Z Sensor vorgesehen, der mit der Auswerteeinheit gekoppelt ist. Weiterhin ist ein Verriegelungsschalter zum Verriegeln der Anzeige des Ladezustandes vorgesehen, wobei der Verriegelungsschalter mit der Auswerteeinheit gekoppelt ist.

In einer bevorzugten Ausführungsform kann der Sensor so ausgeführt werden, dass er Kontakte aufweist, an denen eine Spannung ausgewertet werden kann. Insbesondere kann bei dem als NTC ausgeführtem Sensor ein Spannungspegel an seinen Kontakten abgegriffen werden. Liegt der Spannungspegel des NTC über einem vorgegebenen Schwellwert, so bedeutet dies, dass der Akku entweder von der Maschine, die er antreibt, entladen wird, die Maschine also in Betrieb ist oder dass der Akku gegenwärtig von einem Ladegerät geladen wird. In beiden Fällen unterbleibt eine Anzeige des Ladezustandes.

In einer weiteren Ausführungsform der Erfindung kann der Sensor zum Erfassen, ob die wiederaufladbare Batterie geladen oder entladen wird kann auch magnetisch ausgeführt werden.

Der erfindungsgemäße Akku nach Anspruch 1 und das entsprechende Verfahren zur Anzeige des Ladezustandes einer wiederaufladbaren Batterie eines Akkus nach Anspruch 3 weisen demnach eine wiederaufladbare Batterie mit einer Ladezustandsschaltung mit einer Auswerteeinheit zum Auswerten des Ladezustands der wiederaufladbaren Batterie und einer Ladezustandsanzeige auf. Die Ladezustandsschaltung ist mit einem als NTC ausgeführtem Sensor, der mit der Auswerteeinheit gekoppelt ist, ausgestattet. Weiterhin ist ein Verriegelungsschalter zum Verhindern der Anzeige des Ladezustands vorgesehen, der mit der Auswerteeinheit gekoppelt ist.

Damit kann durch eine kostengünstige elektronische Schaltungsanordnung im Akku die Funktionalität zur Betriebszustandsermittlung zur Verfügung gestellt werden.

Um ein ständiges Anzeigen des Ladezustandes zu unterbinden, wird ein Aktivierungsschalter zum Aktivieren der Ladezustandsschaltung vorgesehen. Der Sensor ist auf einfache Weise als NTC verwirklicht wobei dieser bevorzugt in der Nähe der wiederaufladbaren Batterie vorgesehen wird.Der Spannungspegel der am NTC anliegenden Spannung zeigt, ob die wiederaufladbare Batterie gerade aufgeladen oder entladen wird.

In einer weiteren bevorzugten Ausführungsform der Erfindung ist in der Auswerteeinheit eine Spannungsüberwachung der wiederaufladbaren Batterie integriert. Damit kann erkannt werden, wenn die Spannung der wiederaufladbaren Batterie unter eine minimale Spannung fällt. In diesem Fall kann der Verriegelungsschalter so geschaltet werden, dass eine Anzeige verhindert wird und der Akku kann somit vor einer Tiefentladung geschützt werden.

Mit dem erfindungsgemäßen Akku kann also mit einem Aktivierungsschalter die Ladezustandsschaltung aktiviert werden. Mit dem Sensor kann erfasst werden, ob die wiederaufladbaren Batterie geladen oder entladen wird. In der Auswerteeinheit kann dann in Abhängigkeit von dem Messergebnis ein Verriegelungsschalter deaktiviert und damit eine Anzeige des Ladezustands der wiederaufladbaren Batterie ermöglicht oder der Verriegelungsschalter aktiviert und damit die Anzeige verhindert werden.

Besonders einfach kann dieses Verfahren verwirklicht werden, wenn die Spannung an einem geeignet angeordneten NTC ausgewertet wird. Liegt die Spannung am NTC über einem Schwellwert, etwa über Null, so bedeutet dies, dass der Akku entweder geladen oder durch den Betrieb in der Maschine entladen wird. Der Verriegelungsschalter verhindert dann eine Anzeige des aktuellen Ladezustands. Ist die Spannung kleiner oder gleich einem Schwellwert, etwa kleiner oder gleich Null, so wird der Verriegelungsschalter deaktiviert und der aktuelle Ladezustand wird angezeigt.

Weitere Vorteile und vorteilhafte Ausführungsformen der Erfindung sind Gegenstand der nachfolgenden Figuren sowie deren Beschreibungsteile. Es zeigen im Einzelnen:
- Fig. 1:: schematisch eine Ladezustandsanzeigeschaltung
- Fig. 2:: schematisch den Ablauf des erfindungsgemäßen Verfahrens

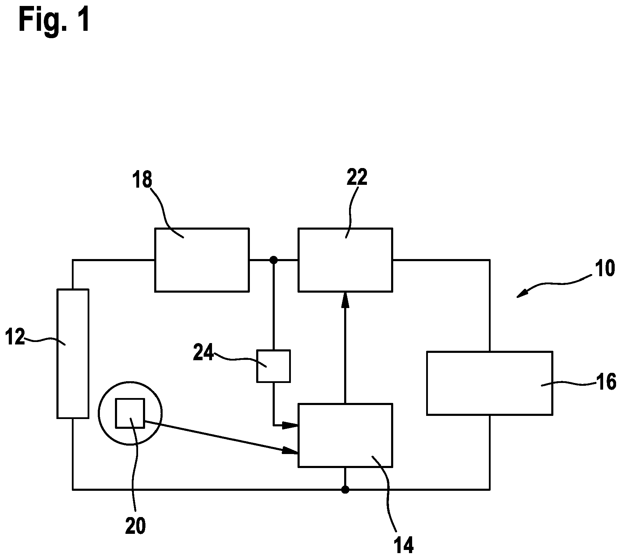

Fig. 1 zeigt schematisch eine Ladezustandsschaltung 10 mit einer wiederaufladbaren Batterie 12. In der Schaltung kann ein Aktivierungsschalter 18 vorgesehen sein, der beispielsweise als mechanischer Taster ausgeführt ist. Wird der Aktivierungsschalter 18 gedrückt, so wird die Ladezustandsschaltung 10 und damit eine Auswerteeinheit 14 mit Strom versorgt. Die Auswerteeinheit 14 prüft über einen Sensor 20, ob die wiederaufladbare Batterie gegenwärtig geladen oder entladen wird. Bevorzugt kann dies dadurch erfolgen, dass als Sensor 20 ein NTC vorgesehen wird, der mit der Auswerteeinheit 14 verbunden ist. Die Auswerteeinheit 14 prüft in diesem Fall den Spannungspegel am NTC und führt einen Vergleich mit einem vorgegebenen Schwellwert durch. Beispielsweise kann die Auswerteeinheit 14 prüfen, ob am NTC eine Spannung anliegt. Ist dies der Fall, so ist der Akku entweder mit einem Ladegerät verbunden und wird geladen oder der Akku wird in einer Maschine benutzt und gegenwärtig wird die wiederaufladbare Batterie 12 entladen. In diesem Fall wird ein in der Ladezustandsschaltung vorgesehener Verriegelungsschalter 22 aktiviert und eine Anzeige des aktuellen Ladezustandes in der im Schaltkreis 10 vorgesehenen Ladezustandsanzeige 16 wird verhindert.

Ergibt die Prüfung in der Auswerteeinheit 14, dass am NTC keine Spannung anliegt, so wird die wiederaufladbare Batterie 12 gegenwärtig weder geladen noch entladen und eine Anzeige des aktuell ermittelten Ladezustands in der Ladezustandsanzeige 16 kann erfolgen. Daher wird von der Auswerteeinheit 14 der Verriegelungsschalter 22 deaktiviert und die Anzeige ermöglicht. Die Ermittlung des Ladezustandes kann wie aus dem Stand der Technik bereits bekannt erfolgen.

Zur weiteren Verbesserung der Ladezustandsschaltung 10 kann in der Auswerteeinheit 14 eine Spannungsüberwachung integriert werden. Schematisch ist hierzu eine Spannungsmessung 24 angedeutet, mit der eine jeweils aktuell anliegende Spannung an der wiederaufladbaren Batterie 12 gemessen und in der Auswerteeinheit 14 verarbeitet werden kann. Sofern ermittelt wird, dass die Spannung der wiederaufladbaren Batterie 12 unter einen minimalen Wert fällt, wird der Verriegelungsschalter ebenfalls aktiviert, so dass damit verhindert werden kann, dass die wiederaufladbare Batterie 12 tiefentladen wird. Somit wird ein entladener Akku nicht durch eine Ladezustandsanzeige weiter belastet und vor einer Tiefentladung geschützt.

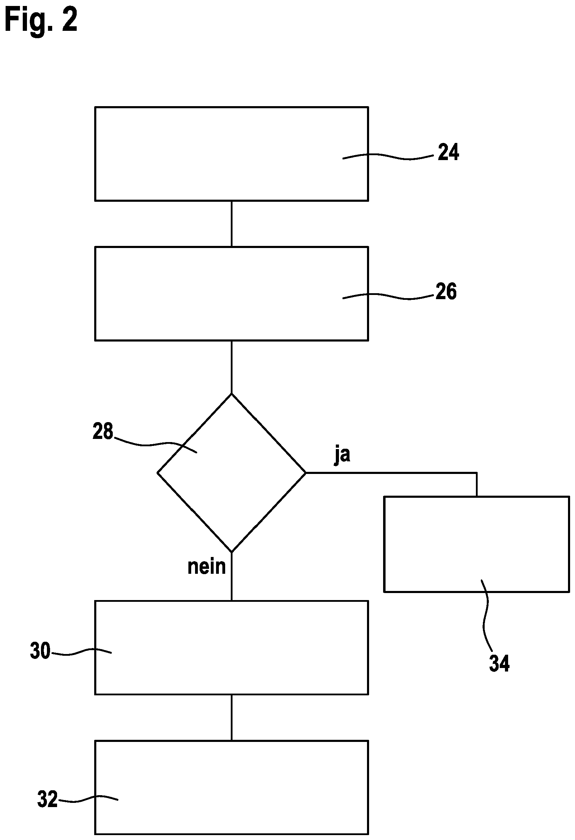

Fig. 2 zeigt schematisch nochmals den grundsätzlichen Ablauf des erfindungsgemäßen Verfahrens. Im Schritt 26 wird von einem Benutzer die Ladezustandsanzeige durch das Drücken eines am Akku vorgesehenen mit einem Aktivierungsschalter 18 aktiviert. Daraufhin wird die Auswerteeinheit 14 mit Strom versorgt. Die Auswerteeinheit 14 prüft, ob der Akku gegenwärtig geladen oder entladen wird. Dies erfolgt beispielsweise mit Hilfe eines an der wiederaufladbaren Batterie 12 vorgesehenen Sensors im Schritt 26, wobei bevorzugt das Spannungssignal eines geeignet an der wiederaufladbaren Batterie 12 angebrachten NTC ausgewertet wird. Im Schritt 28 wird dann geprüft, ob die Auswertung des Temperatursignals den Betriebszustand Laden oder Entladen der wiederaufladbaren Batterie 12 ergibt. Ist dies der Fall, wird der Verriegelungsschalter 22 im Schritt 34 aktiviert und eine Anzeige des aktuellen Ladezustands unterbunden.

Wird im Schritt 28 ermittelt, dass gegenwärtig weder ein Laden noch ein Entladen der wiederaufladbaren Batterie 12 erfolgt, so wird der Verriegelungsschalter 22 im Schritt 30 deaktiviert. Es erfolgt dann im Schritt 32 die Anzeige des aktuellen Ladezustands des Akkus.

Bei der Entscheidung, ob der Verriegelungsschalter 22 aktiviert oder deaktiviert wird, können in der Auswerteeinheit 14 auch weitere Kriterien berücksichtigt werden. Insbesondere kann über eine integrierte Spannungsmessung eine Deaktivierung des Verriegelungsschalters 22 verhindert werden, wenn festgestellt wird, dass die wiederaufladbare Batterie 12 bereits entladen ist.

Mit dem erfindungsgemäßen Akku, der die beschriebene Ladezustandsschaltung 10 aufweist, wird eine kostengünstige elektronische Schaltung bereitgestellt, mit deren Hilfe die Funktionalität von weitaus komplexeren Schaltungsanordnungen verwirklicht werden kann. Dennoch kann bei der Ladezustandsanzeige der jeweilige Betriebszustand des Akkus berücksichtigt werden.

## Patentansprüche

1. Akku für ein Elektrowerkzeug, mit einer wiederaufladbaren Batterie (12) mit einer Ladezustandsschaltung (10), die eine Auswerteeinheit (14) zum Auswerten des Ladezustands der Batterie (12) und eine Ladezustandsanzeige (16) aufweist, wobei ein von einem Bediener bedienbarer Aktivierungsschalter (18) zum Aktivieren der Ladezustandsschaltung (10) vorgesehen ist, und die Ladezustandsschaltung (10) einen als NTC ausgeführten Sensor (20) aufweist, mit dem bestimmbar ist, ob die Batterie geladen oder entladen wird, wobei der Sensor (20) mit der Auswerteeinheit (14) gekoppelt ist, und wobei weiterhin ein Verriegelungsschalter (22) zum Verhindern der Anzeige des Ladezustands vorgesehen ist, wobei der Verriegelungsschalter (22) mit der Auswerteeinheit (14) gekoppelt ist und wobei die Auswerteeinheit (14) den Verriegelungsschalter (22) bei Nichterkennen eines Ladens oder Entladens der Batterie deaktiviert und somit die Ladezustandsschaltung (10) den aktuellen Ladezustand der Batterie (12) abhängig vom Schaltzustand des Aktivierungsschalters anzeigt.

2. Akku nach Anspruch 1, wobei in der Auswerteeinheit (14) eine Spannungsüberwachung der wiederaufladbaren Batterie (12) integriert ist.

3. Verfahren zur Anzeige des Ladezustandes einer wiederaufladbaren Batterie (12) eines Akkus mit einer Ladezustandsschaltung (10), die eine Auswerteeinheit (14) zum Auswerten des Ladezustands der Batterie (12) und eine Ladezustandsanzeige (16) aufweist, wobei
- mit einem von einem Bediener bedienbaren Aktivierungsschalter (18) die Ladezustandsschaltung (10) aktiviert wird,
- mit einem als NTC ausgeführten Sensor (20) bestimmt wird, ob die Batterie (12) geladen oder entladen wird und
- in der Auswerteeinheit (14) ein Verriegelungsschalter (22) deaktiviert und damit eine Anzeige des Ladezustands der wiederaufladbaren Batterie (12) ermöglicht wenn die wiederaufladbare Batterie nicht geladen oder entladen wird oder der Verriegelungsschalter (22) aktiviert und damit die Anzeige verhindert wird, wenn die wiederaufladbare Batterie geladen oder entladen wird.

4. Verfahren nach Anspruch 3, wobei der Verriegelungsschalter (22) von der Auswerteeinheit (14) so geschaltet wird, dass eine Ladezustandsanzeige verhindert wird, wenn die Spannung am NTC größer als ein Schwellwert, insbesondere größer als Null ist.

5. Verfahren nach Anspruch 4, wobei der Verriegelungsschalter (22) von der Auswerteeinheit (14) so geschaltet wird, dass eine Ladezustandsanzeige ermöglicht wird, wenn die Spannung am NTC kleiner oder gleich einem Schwellwert, insbesondere gleich Null ist.

## Claims

1. Accumulator for a power tool, having a rechargeable battery (12) with a charge state circuit (10) comprising an evaluation unit (14) for evaluating the charge state of the battery (12) and a charge state display (16), wherein an activation switch (18) operable by an operator and intended for activating the charge state circuit (10) is provided, and the charge state circuit (10) comprises a sensor (20) which is embodied in the form of an NTC and can be used to determine whether the battery is being charged or discharged, wherein the sensor (20) is coupled to the evaluation unit (14), and wherein an interlock switch (22) for preventing the display of the charge state is furthermore provided, wherein the interlock switch (22) is coupled to the evaluation unit (14), and wherein the evaluation unit (14) deactivates the interlock switch (22) if it is not identified that the battery is being charged or discharged, and therefore the charge state circuit (10) displays the current charge state of the battery (12) depending on the switching state of the activation switch.

2. Accumulator according to Claim 1, wherein voltage monitoring of the rechargeable battery (12) is integrated in the evaluation unit (14).

3. Method for displaying the charge state of a rechargeable battery (12) of an accumulator with a charge state circuit (10) comprising an evaluation unit (14) for evaluating the charge state of the battery (12) and a charge state display (16), wherein
- the charge state circuit (10) is activated using an activation switch (18) operable by an operator,
- a sensor (20) embodied in the form of an NTC is used to determine whether the battery (12) is being charged or discharged, and,
- in the evaluation unit (14), an interlock switch (22) is deactivated and therefore a display of the charge state of the rechargeable battery (12) is made possible if the rechargeable battery is not being charged or discharged, or the interlock switch (22) is activated and therefore the display is prevented if the rechargeable battery is being charged or discharged.

4. Method according to Claim 3, wherein the interlock switch (22) is switched by the evaluation unit (14) in such a way that a charge state display is prevented if the voltage at the NTC is greater than a threshold value, in particular is greater than zero.

5. Method according to Claim 4, wherein the interlock switch (22) is switched by the evaluation unit (14) in such a way that a charge state display is made possible if the voltage at the NTC is less than or equal to a threshold value, in particular is equal to zero.

## Revendications

1. Accumulateur destiné à un outil électrique, comportant une batterie rechargeable (12) ayant un circuit d'état de charge (10) comprenant une unité d'évaluation (14) destinée à évaluer l'état de charge de la batterie (12) et un indicateur d'état de charge (16), dans lequel il est prévu un commutateur d'activation (18) pouvant être actionné par un utilisateur pour activer le circuit d'état de charge (10), et le circuit d'état de charge (10) comporte un capteur (20) réalisé sous la forme d'un NTC, au moyen duquel il est possible de déterminer si la batterie est chargée ou déchargée, dans lequel le capteur (20) est couplé à l'unité d'évaluation (14) et dans lequel il est en outre prévu un commutateur de verrouillage (22) destiné à inhiber l'indication de l'état de charge, dans lequel le commutateur de verrouillage (22) est couplé à l'unité d'évaluation (14) et dans lequel l'unité d'évaluation (14) désactive le commutateur de verrouillage (22) lorsqu'un état de charge ou de décharge de la batterie n'est pas détecté et le circuit d'état de charge (10) indique alors l'état de charge actuel de la batterie (12) en fonction de l'état de commutation du commutateur d'activation.

2. Accumulateur selon la revendication 1, dans lequel une surveillance de la tension de la batterie rechargeable (12) est intégrée à l'unité d'évaluation (14).

3. Procédé d'indication de l'état de charge d'une batterie rechargeable (12) d'un accumulateur muni d'un circuit d'état de charge (10) qui comporte une unité d'évaluation (14) destinée à évaluer l'état de charge de la batterie (12) et un indicateur d'état de charge (16), dans lequel
- le circuit d'état de charge (10) est activé au moyen d'un commutateur d'activation (18) pouvant être actionné par un utilisateur,
- il est déterminé au moyen d'un capteur (20) réalisé sous la forme d'un NTC si la batterie (12) est chargée ou déchargée, et
- un commutateur de verrouillage (22) est désactivé dans l'unité d'évaluation (14) et une indication de l'état de charge de la batterie rechargeable (12) est ainsi rendue possible lorsque la batterie rechargeable n'est pas chargée ou déchargée ou le commutateur de verrouillage (22) est activé et inhibe ainsi l'indication lorsque la batterie rechargeable est chargée ou déchargée.

4. Procédé selon la revendication 3, dans lequel le commutateur de verrouillage (22) est commuté par l'unité d'évaluation (14) de manière à inhiber une indication de l'état de charge lorsque la tension appliquée au NTC est supérieure à une valeur de seuil, notamment supérieure à zéro.

5. Procédé selon la revendication 4, dans lequel le commutateur de verrouillage (22) est commuté par l'unité d'évaluation (14) de manière à permettre une indication de l'état de charge lorsque la tension appliquée au NTC est inférieure ou égale à une valeur de seuil, notamment égale à zéro.
